# EUROPEAN PATENT SPECIFICATION

(11) **EP 0 535 614 B1**
(45) Date of publication and mention of the grant of the patent: **28.04.1999**
(21) Application number: 92116686.4
(22) Date of filing: 29.09.1992
(51) Int. Cl.: H01L 31/05, H01L 27/142, H01L 31/048, H01L 31/042

(54) **Solar battery module**
Solarzellenmodul
Module de cellules solaires

(30) Priority: 30.09.1991 JP 251938/91; 05.06.1992 JP 145844/92
(43) Date of publication of application: 07.04.1993
(73) Proprietor: SHARP KABUSHIKI KAISHA, Osaka-shi Osaka-fu (JP)
(72) Inventor: Asai, Masahito, Shiki-gun, Nara-ken (JP); Nakajima, Shinichi, Osaka-shi, Osaka-fu (JP)
(74) Representative: Müller, Frithjof E., Dipl.-Ing.

(56) References cited:
- EP-A- 0 121 095
- EP-A- 0 369 666
- US-A- 4 481 378
- US-A- 4 759 803
- THE CONFERENCE RECORD OF THE 15TH IEEE PHOTOVOLTAIC SPECIALISTS CONFERENCE 1981 12 May 1981 , KISSIMEE, FLORIDA, US pages 997 - 1000 GIULANO ET AL. 'BY-PASS DIODE DESIGN, APPLICATION AND RELIABILITY STUDIES FOR SOLAR CELL ARRAYS'
- PATENT ABSTRACTS OF JAPAN vol. 015, no. 078 (E-1037)22 February 1991 & JP-A-02 298 080 (SHARP CORP) 10 December 1990
- PATENT ABSTRACTS OF JAPAN vol. 005, no. 133 (E-071)25 August 1981 & JP-A-56 069 871 (FUJI ELECTRIC CO LTD) 11 June 1981

## Description

### BACKGROUND OF THE INVENTION

### Field of the Invention

The present invention relates to a solar battery module in accordance with precharacterising part of claim 1. Such a solar battery module is known from US-A-4 481 378.

### Description of the Background Art

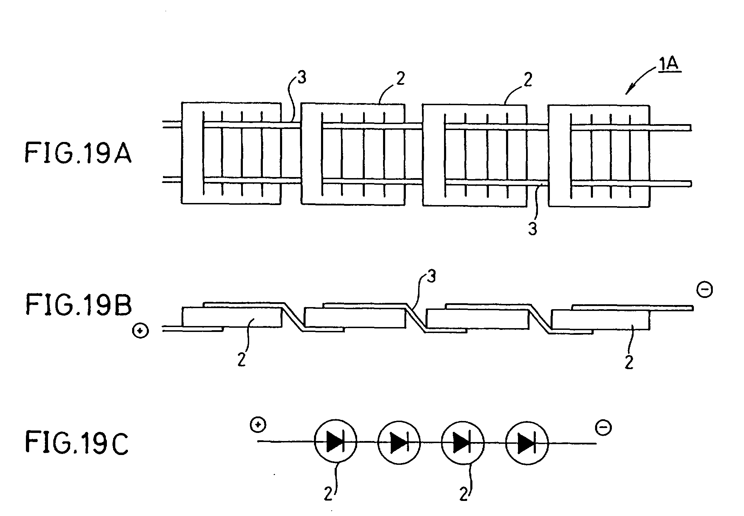

With reference to Figs. 19A, 19B and 19C, one example of a conventional solar battery module is illustrated. Figs. 19A, 19B and 19C show, respectively, a top plan view, a longitudinal cross-sectional view and an equivalent circuit diagram of the solar battery module. In general, a solar battery module 1A includes a plurality of solar cells 2 which are electrically series-connected by an interconnector 3 so as to obtain a desired output voltage. In the solar battery module 1A having such structure that the plurality of solar battery cells 2 are series-connected, however, even in a case where one solar battery cell 2 in the module is shaded, whereas other cells 2 are unshaded, the solar battery module 1A is greatly affected by the single shaded cell 2, resulting in a substantial decrease in the output of the entire module 1A.

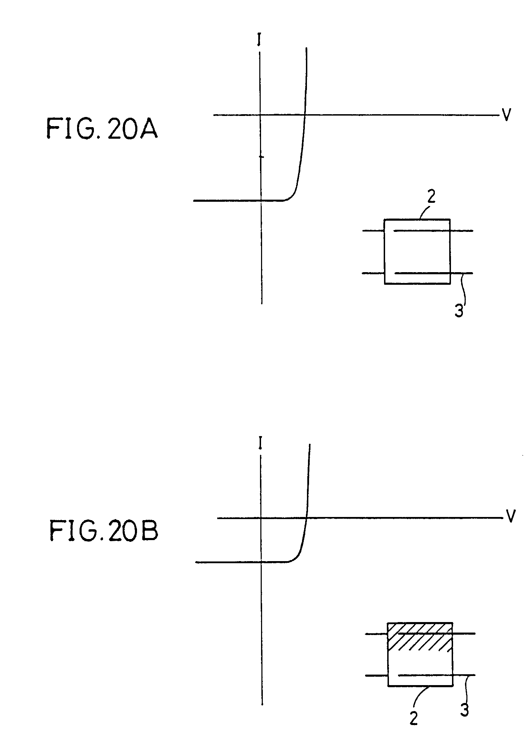

Figs. 20A and 20B show output voltage-current (V-I) characteristics of one solar battery cell 2. In the graph of each of Figs. 20A and 20B, a horizontal axis represents a voltage V, and a longitudinal axis represents a current I. Fig. 20A shows V-I characteristics provided when one overall solar battery cell 2 is irradiated with light, and Fig. 20B shows V-I characteristics provided when about a half of one solar battery cell 2 is shaded. As can be understood from a comparison between Figs. 20A and 20B, the output current I of the half-shaded solar battery cell 2 decreases to approximately a half of the cell 2 which is entirely irradiated with light.

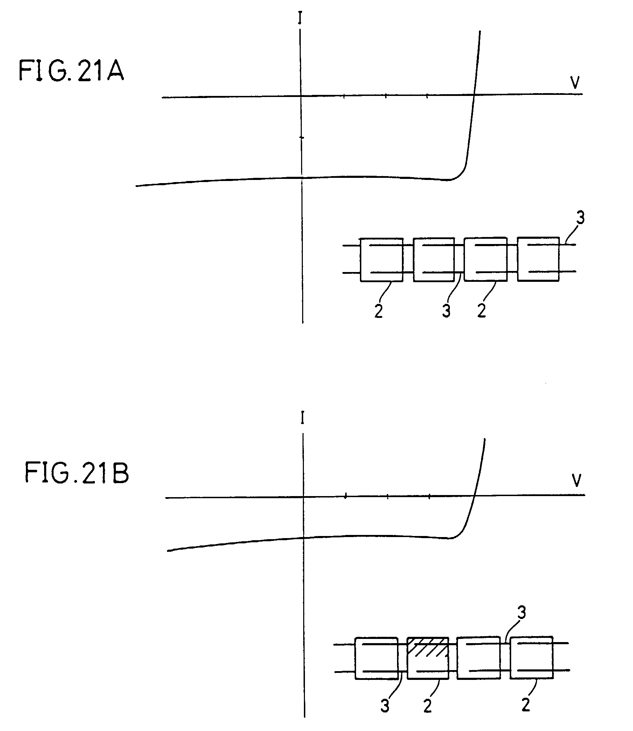

Figs. 21A and 21B are similar to Figs. 20A and 20B and show V-I characteristics of one overall solar battery module 1A. Fig. 21A shows V-I characteristics provided when all of the solar battery cells 2 in the module 1A are irradiated with light, and Fig. 21B shows V-I characteristics provided when approximately a half of one solar battery cell 2 in the module 1A is shaded. As will be apparent from a comparison between Figs. 21A and 21B, even in the case where approximately a half of only one solar battery cell 2 in the module 1A is shaded, the solar battery module 1A is under such an influence that the output current I of the entire module 1A decreases to approximately a half.

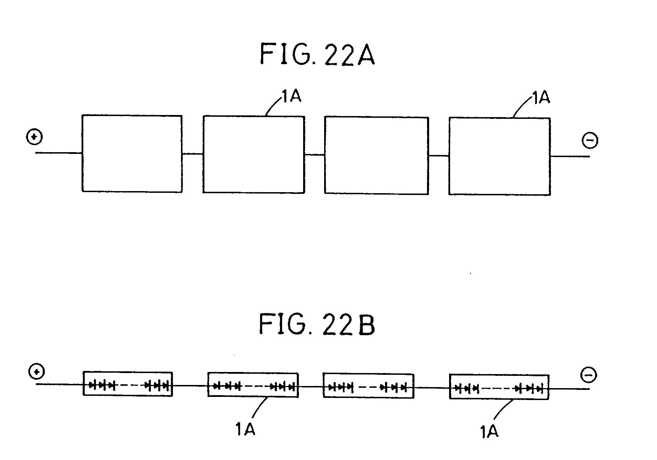

With reference to Figs. 22A and 22B, one example of a solar battery system in which a plurality of solar battery modules 1A are further series-connected is schematically shown. Figs. 22A and 22B show, respectively, a block diagram and an equivalent circuit diagram of that solar battery system. In this solar battery system also, even if only one of the solar battery cells in the system is shaded, the same output decrease as shown in Fig. 21B occurs.

Moreover, in the above-described solar battery module and solar battery system, a large reverse bias voltage is applied to a shaded solar battery cell, so that the shaded cell is destroyed depending on some external circuit connected with the solar battery module or the solar battery system. In some extreme case, solar battery cells are overheated by the reverse bias voltage, causing a fire in a case with a solar battery module installed on a roof.

In order to eliminate the problems of the output decrease in the solar battery module or the breakdown of the cell, a solar battery module incorporating a bypass diode is known in prior art.

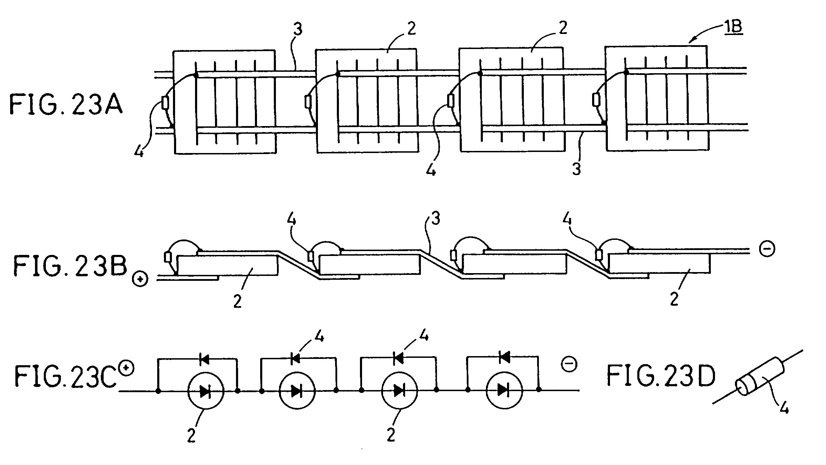

Figs. 23A, 23B and 23C are similar to Figs. 19A, 19B and 19C and illustrate one example of a solar battery module incorporating a bypass diode according to prior art. Figs. 23A, 23B and 23C show, respectively, a top plan view, a longitudinal cross-sectional view and an equivalent circuit diagram of a solar battery module 1B. Fig. 23D is a perspective view showing one bypass diode. In this solar battery module 1B, bypass diodes 4 are connected in parallel in reverse polarity with respect to respective solar battery cells 2 included in the module 1B.

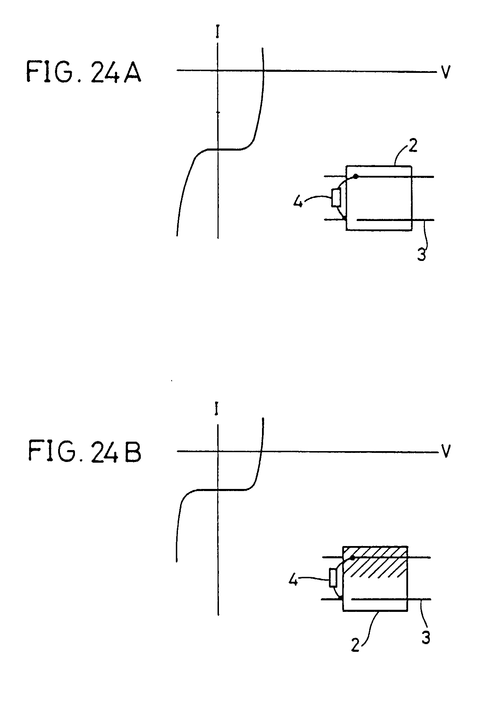

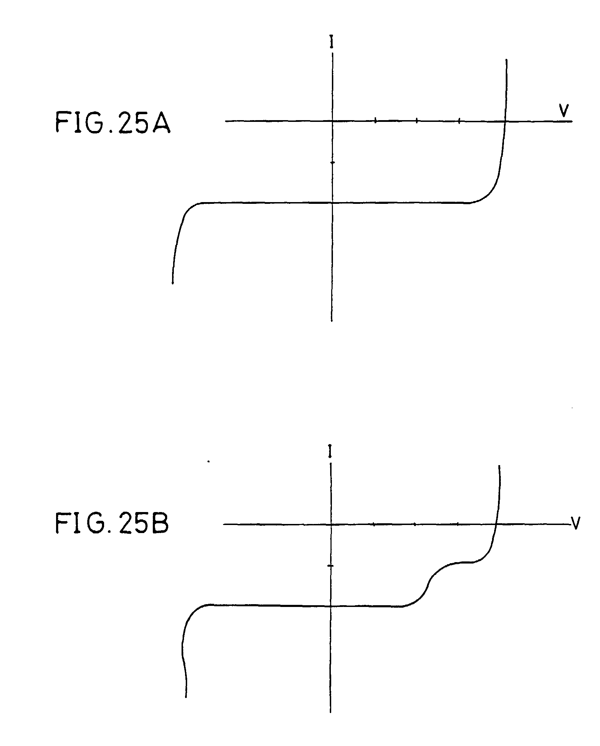

Figs. 24A, 24B, 25A and 25B are similar to Figs. 20A, 20B, 21A and 21B, respectively, and show output V-I characteristics in the solar battery module 1B of Fig. 23A. Figs. 24A and 24B show output V-I characteristics of one solar battery cell 2 incorporating a bypass diode 4. As can be understood from a comparison with Figs. 20A and 20B, when there is one solar battery cell 2, the bypass diode 4 does not reduce a decrease in the output of the shaded solar battery cell 2. When a reverse bias voltage externally acts on the solar battery cell 2, however, the bypass diode 4 can act to release the reverse bias voltage and protect the solar battery cell 2 from breakage due to the reserve bias voltage.

Fig. 25A shows V-I characteristics provided when all of the solar battery cells 2 in the solar battery module 1B of Fig. 23A are irradiated with light, and Fig. 25B shows V-I characteristics provided when approximately a half of one solar battery cell 2 in the module 1B is shaded.

As can be understood from a comparison between Figs. 25B and 21B, the bypass diode 4 can act to minimize a decrease in the output of the entire module 1B when a part of solar battery cells 2 in the solar battery module 1B are shaded.

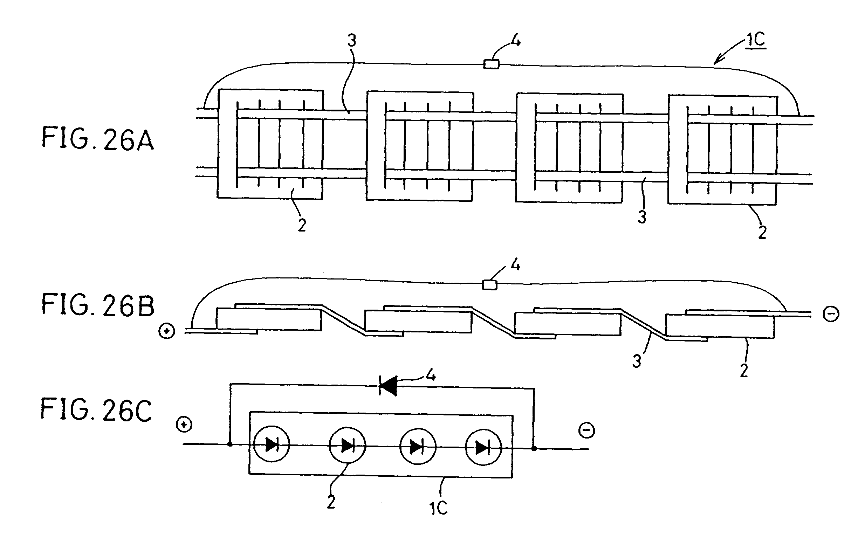

With reference to Figs. 26A, 26B and 26C, one example of one solar battery module incorporating one bypass diode is illustrated. Figs. 26A, 26B and 26C show, respectively, a top plan view, a longitudinal cross-sectional view and an equivalent circuit diagram of a solar battery module 1C. The solar battery module 1C including a desired number of series-connected solar battery cells 2 includes one bypass diode 4 connected in parallel in a reverse polarity to the solar battery module 1C. When a part of solar battery cells 2 in the solar battery module 1C are shaded, this bypass diode 4 does not reduce a decrease in the output of the entire module 1C; however, when a reverse bias voltage acts on the module 1C, the bypass diode 4 can act to protect the entire module 1C from breakdown due to the applied reverse bias voltage.

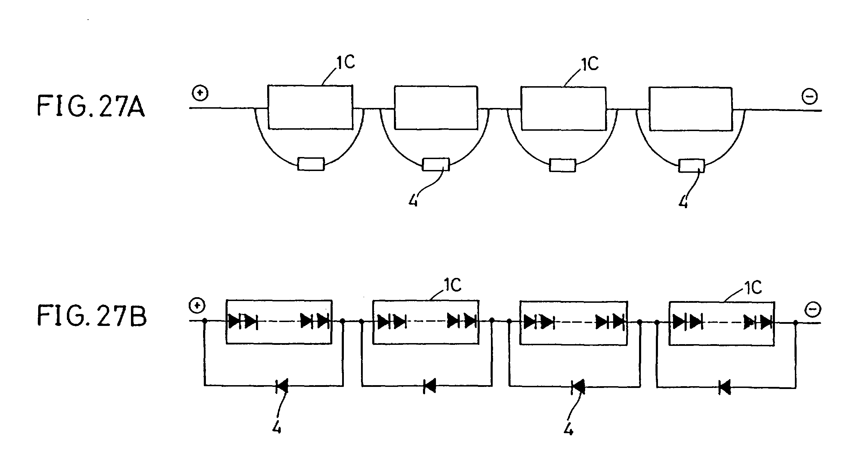

With reference to Figs. 27A and 27B, a solar battery system including one bypass diode for each solar battery module is schematically illustrated. Figs. 27A and 27B show, respectively, a block diagram and an equivalent circuit diagram of that solar battery system. This solar battery system includes a plurality of series-connected solar battery modules 1C, each solar battery module 1C including one bypass diode 4. Those bypass diodes 4 can act to reduce a decrease in the output of the entire solar battery system even in a case where a part of solar battery cells in the solar battery modules 1C are shaded.

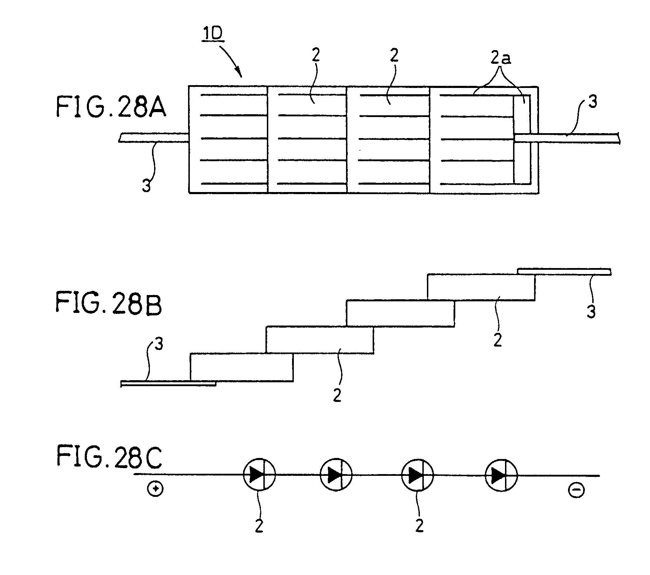

With reference to Figs. 28A, 28B and 28C, another example of a conventional solar battery module is illustrated. Figs. 28A, 28B and 28C show, respectively, a top view, a longitudinal cross-section view and an equivalent circuit diagram of a solar battery module 1D. The module ID of Figs. 28A, 28B and 28C is similar to the module 1A of Figs. 19A, 19B and 19C; however, with reference to Figs. 28A, 28B and 28C, a plurality of relatively small solar battery cells 2 each having a comb tooth-like front electrode 2a are electrically series-connected in such a manner that a portion of each solar battery cell 2 is overlapped with a portion of each adjacent cell 2, a so-called roof-tile-stacked manner. A back electrode (not shown) is formed on an approximately overall back surface of each of those small solar battery cells 2, and a portion of the front electrode 2a of one solar battery cell 2 is directly attached to the back electrode of its adjacent solar battery cell 2. Solar battery cells 2 on opposite ends of a series of the roof-tile-stacked solar battery cells 2 are connected with interconnecters 3.

In the roof-tile-stacked solar battery module 1D shown in Figs. 28A, 28B and 28C also, when a part of solar battery cells 2 are shaded, there occurs the same problem of a substantial decrease in output current as described in Figs. 21A and 21B.

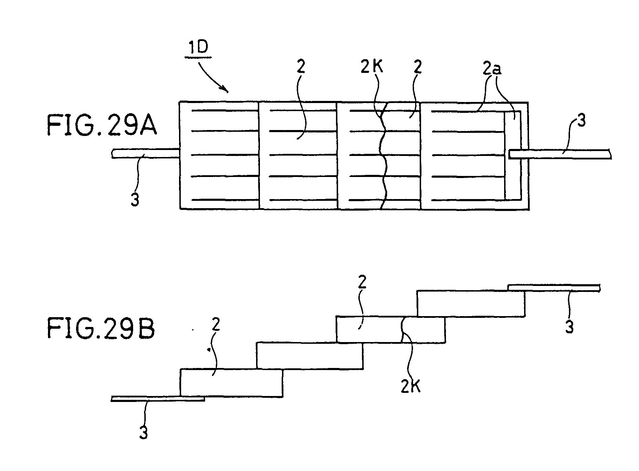

In addition, since the roof-tile-stacked solar batter module 1D has a poor flexibility, a crack is liable to be produced in a direction orthogonal to an elongated direction of that module, as illustrated in Figs. 29A and 29B. This crack is liable to be produced particularly in a long solar battery module in which a large number of solar battery cells 2 are connected in series. Figs. 29A and 29B show, respectively, a top view and a longitudinal cross-sectional view of the solar battery module 1D including a cracked solar battery cell 2. When a crack 2K is running completely across one solar battery cell 2 as shown in Figs. 29A and 29B, an output of the entire solar battery module 1D decreases down to 0.

The diode 4 of the type shown in Fig. 23D is employed in the solar battery module incorporating the prior art bypass diode 4. This diode 4 has usually a cylindrical form of approximately 3-4mm in diameter and approximately 10mm in length. On the other hand, the solar battery cell 2 has a thin plate form of, e.g., 100 x 100 x 0.4mm³ in size.

Accordingly, when the solar battery module is laminated with and interposed between protection layers, the thin solar battery cell 2 sometimes cracks by being pressed by the thick diode 4. In addition, the overall laminated solar battery module becomes thick due to the thick diode 4, resulting in an increase in the overall weight of the module. Moreover, there is such a problem that if the diode 4 is provided in portions other than the solar batter cell, the size of the entire solar battery module becomes increased by the proportion corresponding to the provision of the diode 4, and a module conversion efficiency (a photoelectric conversion efficiency of the module with respect to an outer size of the module) becomes decreased, resulting in a deterioration in the appearance of the product and a degradation in the value of the commodity. There is another problem that since the diode 4 is thick, a laminating step becomes complicated, resulting in a higher cost of the product.

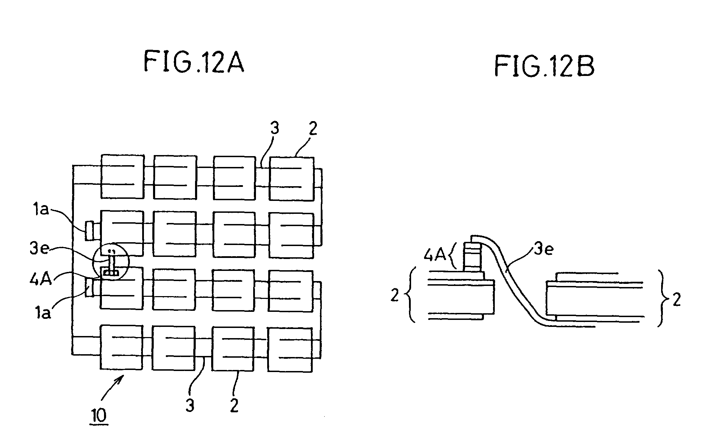

Moreover, in a solar battery module in which solar battery cells having a thin plate form and a relatively small size of, e.g., 30 x 30 x 0.4mm³ are roof-tile-stacked, a crack is liable to be produced in the directionorthogonal to the elongated direction of the module asshown in Figs. 29A and 29B. This resuls in such aproblem that the output of the solar battery module is 0. US-A-4 481 378 disclosing an known solar battery module in accordance with the precharacterising part of claim 1 proposes to attach a bypass diode connected in reverse connection to a respective solar battery cell at the back surface thereof to an adjacent solar battery cell. From the bypass diode two interconnectors are leading to the back and front side of said adjacent solar battery cell one connector from the cathode and the other from the anode of the bypass diode (c.f. fig.12).

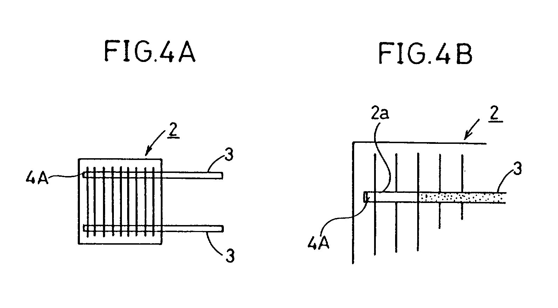

The Fifteenth IEEE Photovoltaic Specialists Conference 1981, 12 May 1981, KISSIMEE , Florida pages 997-1000 (cf. Figure 4) discloses to attach a thin pellet like bypass diode to a back side of the solar cell.
EP-A-0121095 proposes to directly integrate bypass diodes in the solar cell module. This document proposes to directly connect the bypass diode between two solar cells, to attach the bypass diode with one electrode directly on the backside of one solar cell and to connect it with its second electrode by an interconnector stripe with the backside of the other solar cell or to connect the bypass diode between one solar cell and a interconnector stripe connecting to other solar cells.

### SUMMARY OF THE INVENTION

In view of the above-described problems of the prior art, one object of the present invention is to provide a solar battery module which has a good appearance and a high value as a commodity and can be easily thinly laminated together with protection layers at a low cost without damaging thin solar battery cells.

The above object is, according to an essential aspect of the invention, solved by a solar battery module, comprising:
- a plurality of solar battery cells which are electrically series-connected and arranged in a matrix array of rows and columns, each of said cells including a front electrode and a back electrode, each front electrode including a plurality of parallel conductors located on a light receiving front side of each cell and extending in one direction, and
- at least one pellet-like thin bypass diode which allows output currents of said solar battery cells to be by-passed with respect to at least one of said solar battery cells, said bypass diode being attached on an electrode of said solar battery cell,
**characterized in that** each of said solar battery cells includes one bypass diode, which is directly attached to one of said parallel conductors of a front electrode of a cell and to an adjacent cell by an interconnector wherein said one bypass diode is on a line in which said interconnectors are aligned, and in that a bypass diode is provided for each of two adjacent rows of said matrix array allowing output currents of said solar battery cells of the respective two adjacent rows to be bypassed with respect to said plurality of solar battery cells, said bypass diode being attached to the front electrode of the end cell of one of said row and connected by means of a connector to an electrode of the end cell of the adjacent row.

Depending claims 2 to 8 are respectively specifying advantageous developments thereof.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1A, 1B and 1C are diagrams schematically showing one example of a solar battery cell for use in a solar battery module of the present invention.

Figs. 2A, 2B and 2C are diagrams schematically showing one example of a pellet-like thin bypass diode for use in the solar battery module of the present invention.

Figs. 3A, 3B and 3C are diagrams showing the step of attaching a bypass diode on an electrode of a solar battery cell.

Figs. 4A and 4B are diagrams showing the step of connecting an interconnector on the electrode of the solar battery cell.

Figs. 5A, 5B and 5C are diagrams showing the step of attaching a diode interconnector on the bypass diode.

Figs. 6A and 6B are diagrams showing a solar battery module in which a plurality of solar battery cells are series-connected by interconnectors.

Figs. 7A, 7B and 7C are diagrams showing the step of laminating the solar battery module together with protection layers.

Figs. 8A and 8B are diagrams showing a solar battery module.

Figs. 9A and 9B are diagrams showing a solar battery module.

Figs. 10A and 10B are diagrams showing a solar battery module according to an embodiment of the present invention.

Figs. 11A and 11B are diagrams showing a solar battery module according to a further embodiment of the present invention.

Figs. 12A and 12B are diagrams showing a solar battery module according to a still further embodiment of the present invention.

Figs. 13A and 13B are diagrams showing a solar battery module according to a still further embodiment of the present invention.

Fig. 14 is an equivalent circuit diagram showing a solar battery module according to a still further embodiment of the present invention.

Figs. 15A, 15B, 15C and 15D are diagrams showing a roof-tile-stacked solar battery module which is not in accordance with the present invention.

Figs. 16A, 16B and 16C are diagrams showing the state where a crack is produced in the roof-tile-stacked solar battery module of Figs 15A, 15B and 15C.

Figs. 17A, 17B and 17C are diagrams showing the step of assembling the roof-tile-stacked solar battery module of Fig. 15C.

Fig. 18 is a diagram showing a roof-tile-stacked solar battery module which is not in accordance with the present invention.

Figs. 19A, 19B and 19C are diagrams showing one example of a conventional solar battery module.

Figs. 20A and 20B are diagrams showing output voltage-current (V-I) characteristics of one solar battery cell.

Figs. 21A and 21B are diagrams showing V-I characteristics of one entire solar battery module.

Figs. 22A and 22B are diagrams showing one example of a conventional solar battery system including a plurality of solar battery modules.

Figs. 23A, 23B and 23C are diagrams showing one example of a solar battery module incorporating a prior art bypass diode.

Figs. 24A and 24B are diagrams showing V-I characteristics of one prior art solar battery cell including a bypass diode.

Figs. 25A and 25B are diagrams showing V-I characteristics in one prior art solar battery module including a bypass diode.

Figs. 26A, 26B and 26C are diagrams showing one example of a prior art solar battery module including only one bypass diode.

Figs. 27A and 27B are diagrams showing a prior art solar battery system including one bypass diode for each solar battery module.

Figs. 28A, 28B and 28C are diagrams showing a conventional roof-tile-stacked solar battery module.

Figs. 29A and 29B are diagrams showing the state where a crack is produced in the roof-tile-stacked solar battery module of Figs. 28A and 28B.

### DESCRIPTION OF THE PREFERRED EMBODIMENTS

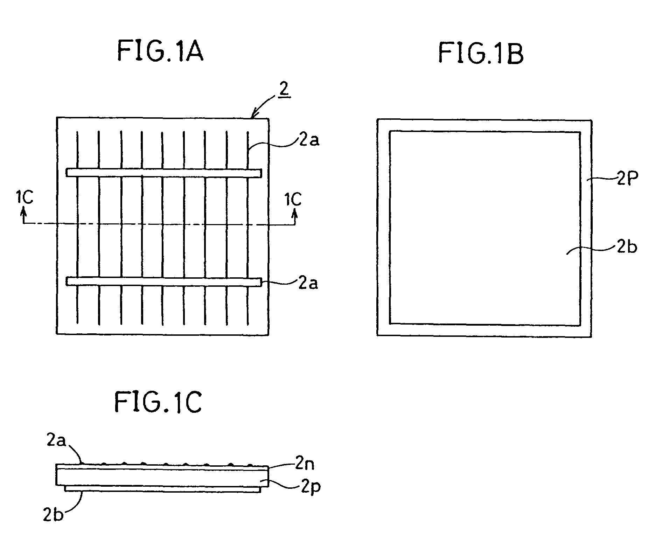

With reference to Figs. 1A, 1B and 1C, one example of a solar battery cell for use in a solar battery module according to one embodiment of the present invention is schematically illustrated. Figs. 1A and 1B are, respectively, a top plan view and a bottom plan view of the solar battery cell; and Fig. 1C is a cross-sectional view taken along a line 1C-1C of Fig. 1A. In this solar battery cell 2, an n type semiconductor layer 2n is formed on one main surface of a p type semiconductor substrate 2p. A front electrode 2a is formed on the n type layer 2n, while a back electrode 2b is formed on the other main surface of the p type substrate 2p. The solar battery cell 2 is of a thin plate form having a size of, e.g. 100 x 100 x 0.4mm³.

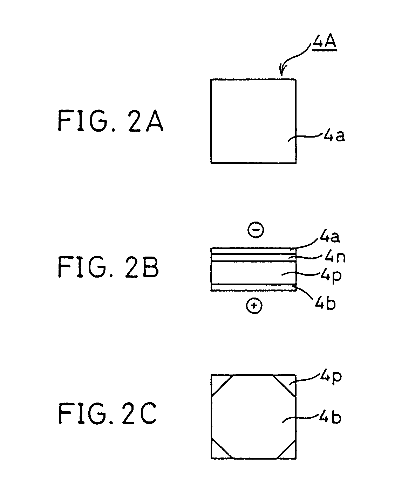

With reference to Figs. 2A, 2B and 2C, one example of a pellet-like bypass diode employed in a solar battery module according to one embodiment of the present invention is schematically illustrated. Figs. 2A, 2B and 2C are, respectively, a top plan view, a side view and a bottom view of the pellet-like diode. In this pellet-like diode 4A, an n type semiconductor layer 4n is formed on one main surface of a p type semiconductor substrate 4p. A front electrode 4a is formed on the n type layer 4n, while a back electrode 4b is formed on the other main surface of the p type substrate. As can be understood from Figs. 2A and 2C, the back electrode 4b has a different shape from that of the front electrode 4a so as to easily distinguish the front and the back of the diode 4A. Those front and back electrodes 4a and 4b are coated with solder.

This pellet-like diode 4A is of a thin plate form having a size of, e.g., 3 x 3 x 0.4mm³. That is, the pellet-like diode 4A has a thickness of 0.4mm far smaller than a thickness 3-4mm of the conventional diode 4 shown in Fig. 23D.

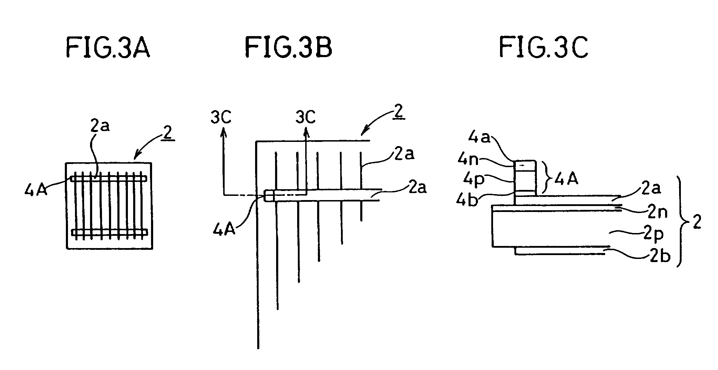

With reference to Figs. 3A, 3B and 3C, the step of attaching a bypass diode on an electrode of a solar battery cell is illustrated. Referring to Fig. 3A, the pellet-like diode 4A is mounted on one end of the front electrode 2a of the solar battery cell 2, then heated and soldered thereon. Fig. 3B is a partially enlarged view of the solar battery cell 2 with the pellet-like diode 4A attached thereon; and Fig. 3C is an enlarged cross-sectional view taken along a line 3C-3C of Fig. 3B.

With reference to Figs. 4A and 4B, the step of attaching an interconnector 3 for series-connecting a plurality of solar battery cells 2, on the front electrode 2a of the solar battery cell 2. Fig. 4A shows the solar battery cell 2 on which the pellet-like diode 4A and the interconnector 3 are attached; and Fig. 4B is a partially enlarged view of Fig. 4A.

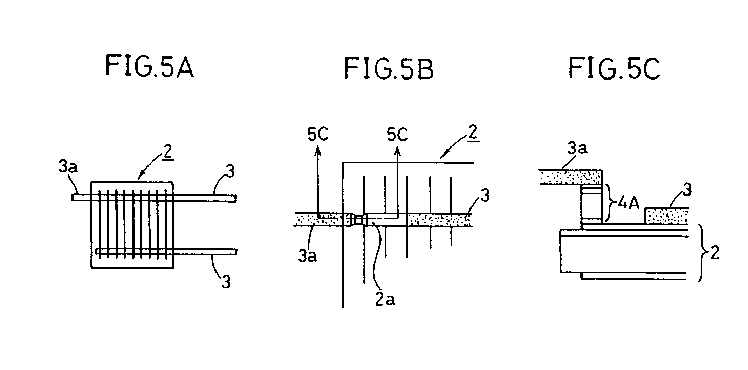

Referring to Fig. 5A, an interconnector 3a for electrically connecting the bypass diode 4A is soldered on the diode 4A. Fig. 5B is a partially enlarged view of the solar battery cell 2 with the diode interconnector 3a attached on the bypass diode 4A; and Fig. 5C is an enlarged cross-section view taken along a line 5C-5C of Fig. 5B. While the diode interconnector 3a is attached after the diode 4A is attached on the solar battery cell 2 in this embodiment, the diode 4A may be attached on the solar battery cell 2 after the diode interconnector 3a is attached in advance on the diode 4A.

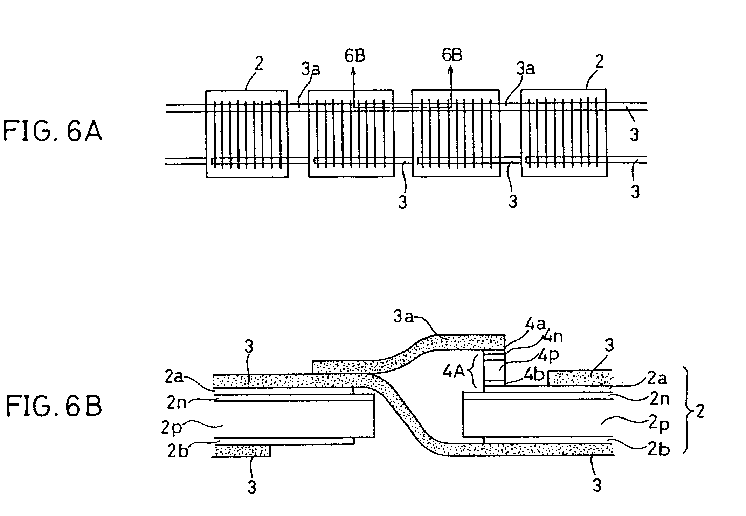

Fig. 6A is a front view of a solar battery cell module in which a plurality of solar battery cells 2 are series-connected. Fig. 6B is an enlarged cross-sectional view taken along a line 6B-6B of Fig. 6A. In this solar battery module, each of the solar battery cells 2 includes the bypass diode 4A connected on its front electrode 2a. The bypass diode 4A is connected to the front electrode 2a of any adjacent solar battery cell 2 by the diode interconnector 3a.

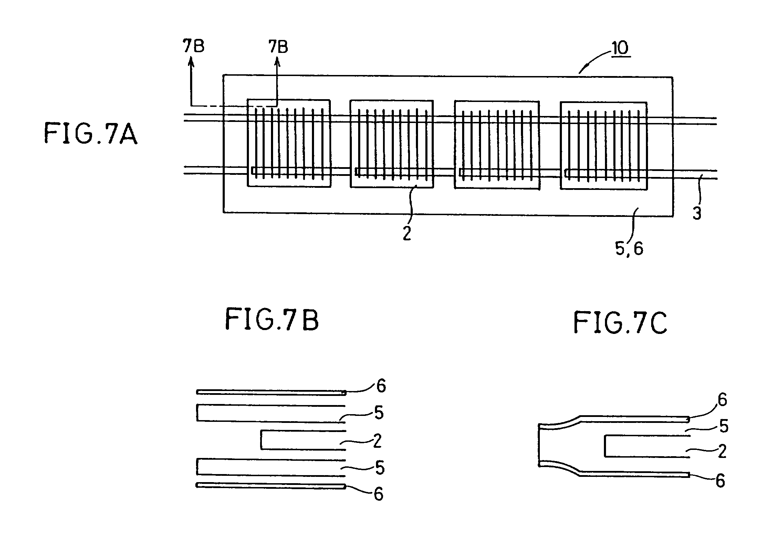

Referring to Fig. 7A, the solar battery module of Fig. 6A is laminated with and interposed between protection layers. Fig. 7B is an enlarged cross sectional view taken along a line 7B-7B of Fig. 7A. The solar battery cell 2 is interposed between filling resin layers 5 such as of an EVA resin and transparent films 6 on the outside of the filling resin layers 5. After that, these protection layers 5 and 6 are heated under pressure. Consequently, the solar battery cell 2 is laminated with the protection layers 5 and 6 adhering each other as shown in Fig. 7C, thereby completing a solar battery module 10.

In assembly of the above solar battery module, complicated interconnections or connections which have been required between the conventional bypass diode 4 and the solar battery cell 2 are simplified, enabling a reduction in manufacturing cost. In addition, since the bypass diode 4A is directly connected to a solar battery cell plate, it is possible to allow a heat generated when a current flows through the bypass diode 4A to efficiently escape through the solar battery cell plate, and thus prevent overheating of the bypass diode 4A.

Further, since the pellet-like bypass diode 4A has a thickness of 0.4mm far smaller than the thickness 3-4mm of the conventional normal diode, the above-described laminated solar battery cell does not become thick, or the thin solar battery cell 2 is not damaged by being pressed by the conventional thick bypass diode. Moreover, since the thin pellet-like bypass diode is aligned along the interconnector 3, the finished solar battery module 10 has a good appearance and a high value as commodities.

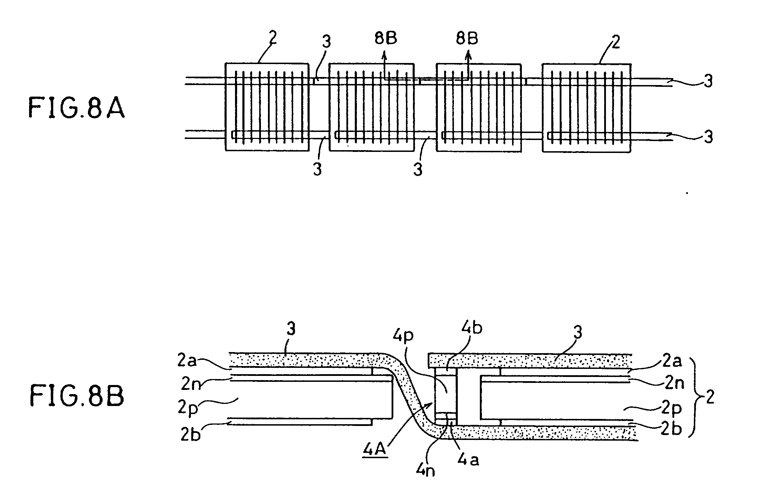

Fig. 8A shows a front view of a solar battery module. Fig. 8B shows an enlarged cross-sectional view taken along a line 8B-8B of Fig. 8A. In this solar battery module, a pellet-like bypass diode 4A is attached in parallel with each of solar battery cells 2 and between interconnectors 3 which are attached, respectively, on a front and a back of each solar battery cell 2. In that case, since the bypass diode 4A has a thickness of approximately 0.4mm identical to that of the solar battery cell 2, the bypass diode 4A does not increase the thickness of the solar battery module. Although the solar battery module of Figs. 8A and 8B is laminated together with protection layers 5 and 6 in the same manner as described in association with Figs. 7A, 7B and 7C, the bypass diode 4A does not apply an undesired force to the solar battery cell 2 during pressure attachment at that time.

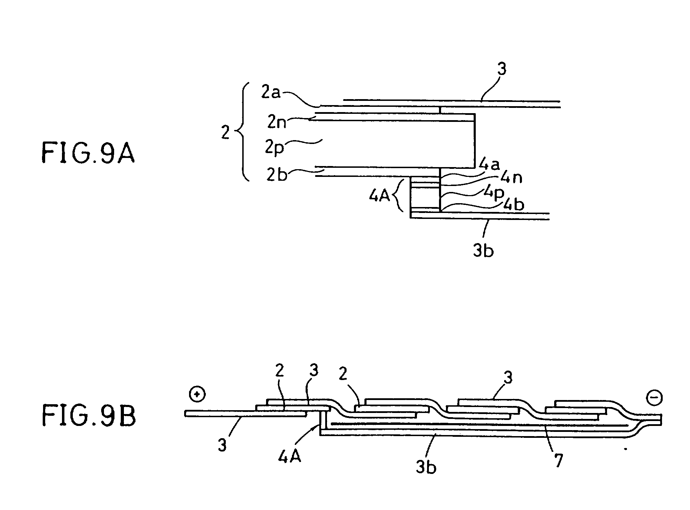

With reference to Figs. 9A and 9B, still another solar battery cell is illustrated. In this embodiment, as shown in an enlarged partial cross-sectional view of Fig. 9A, a pellet-like bypass diode 4A is attached on a back electrode 2b of one solar battery cell 2. An interconnector 3 for series-connecting a plurality of solar battery cells 2 is attached on a front electrode of that solar battery cell 2, and a bypass interconnector 3b is attached on a lower electrode 4b of the bypass diode 4A.

Fig. 9B shows a solar battery module including a plurality of solar battery cells 2 which are electrically connected by the interconnectors 3 and 3b. In this case, the bypass interconnector 3b is electrically insulated from the other interconnector 3 or the like by an insulating sheet 7. As will be understood from Fig. 9B, when a reverse bias voltage is generated in this solar battery module, not each of individual solar battery cells 2 but one entire solar battery module is bypassed via the bypass diode 4A and the bypass interconnector 3b. The solar battery module of Fig. 9B is also laminated together with the same protection layers as described in association with Figs. 7A, 7B and 7C.

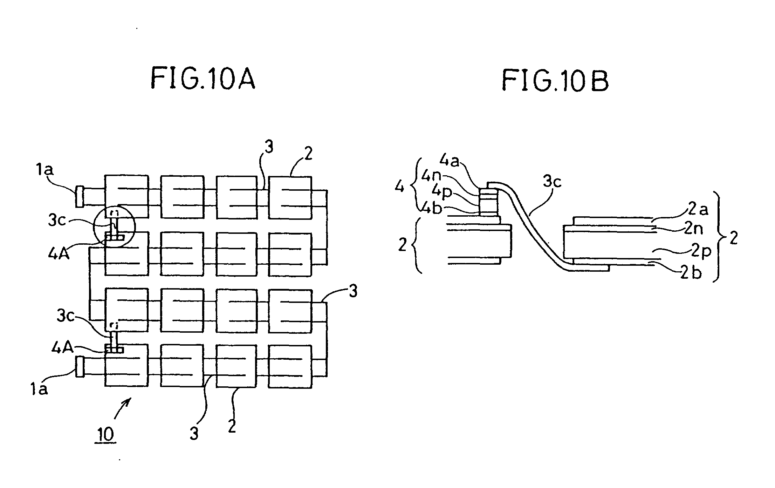

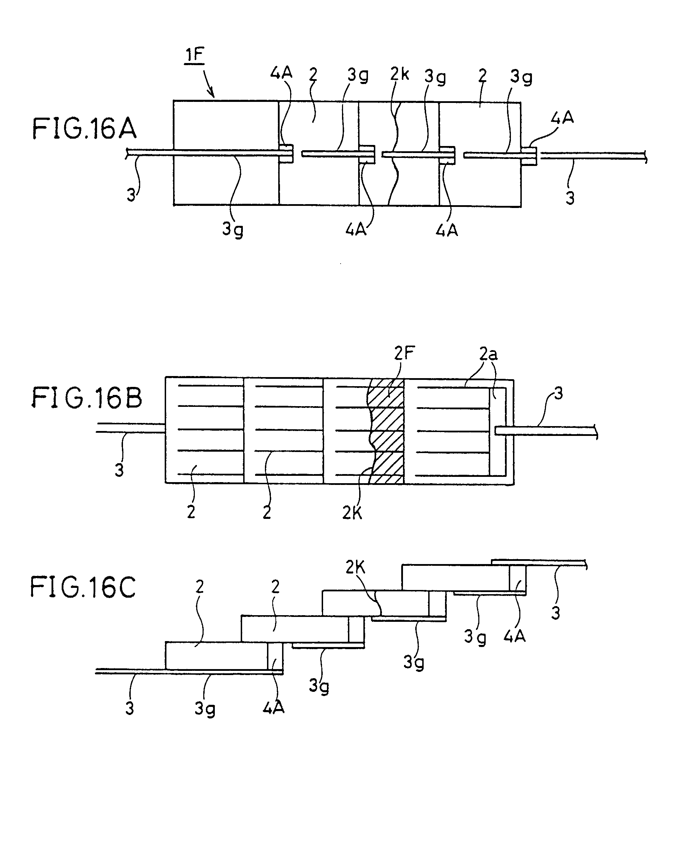

With reference to Figs. 10A and 10B, an embodiment of the invention is illustrated. In a solar battery module 10 of Fig. 10A, 16 solar battery cells 2 arranged in a matrix of 4 rows and 4 columns are series-connected between two output terminals 1a. Fig. 10B shows an enlarged cross-sectional view of an encircled part in Fig. 10A. A pellet-like bypass diode 4A attached on a front electrode 2a of one solar battery cell 2 is connected to a back electrode of another solar battery cell 2 on its adjacent row by a diode interconnector 3c. That is, in the solar battery module of Fig. 10A, when a reverse bias voltage is generated, every two-row solar battery cells 2, i.e., 8 solar battery cells 2 are bypassed via the diode 4A and the diode interconnector 3c. In that case, since the diode interconnector 3c is connected to its adjacent solar battery cell 2, the interconnector 3c can be made far shorter than the bypass interconnector 3b shown in Fig. 9B, and does not require any insulating sheet 7. The solar battery module of Fig. 10A is also laminated together with the same protection layers as described in association with Figs. 7A, 7B and 7C.

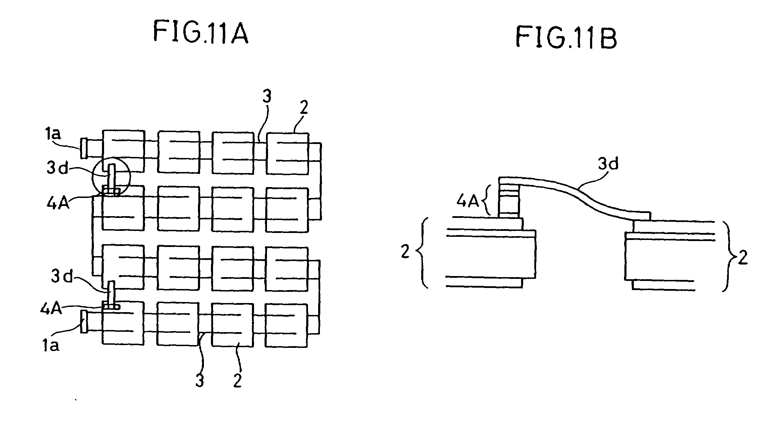

With reference to Figs. 11A and 11B, still another embodiment is illustrated. While this embodiment is similar to the embodiment of Figs. 10A and 10B, a diode interconnector 3d is connected to a front electrode not a back electrode of an adjacent solar battery cell 2 of a solar battery cell 2 on which a bypass diode 4A is mounted. In this case, since the diode interconnector 3d is connected on a top surface of each of the diode and the solar battery cell 2, the step of attaching the diode interconnector 3d is made easier. In that case, the solar battery cell 2 in which the diode interconnector is attached on its front electrode 2a is not allowed to be bypassed; however, the number of such cells is only two out of 16 cells included in the module, and hence, a sufficiently meaningful bypass function can be exhibited in practice.

With reference to Figs. 12A and 12B, still another embodiment is illustrated. This embodiment is similar to that of Figs. 10A and 10B, but a solar battery module 10 has only one bypass diode 4A. That is, as will be apparent from Figs. 10A and 10B, two cells 2 which are on opposite ends of series-connected solar battery cells 2 and are directly connected to two output terminals 1a are arranged adjacently, and a bypass circuit is formed between these two cells 2 on the opposite ends. Thus, when a reverse bias voltage is generated, the entire solar battery module 10 is bypassed.

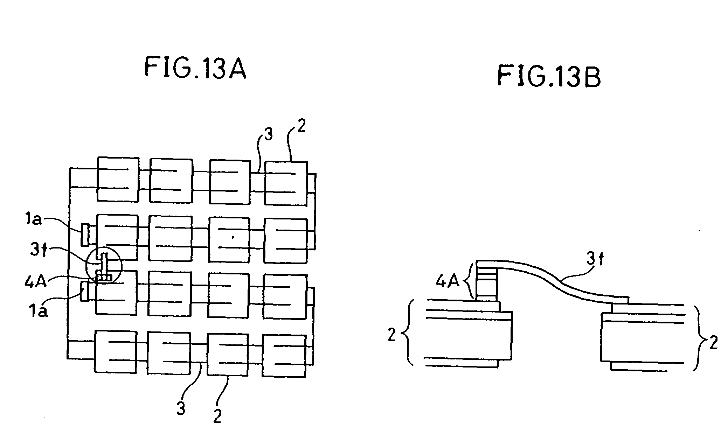

With reference to Figs. 13A and 13B, still another embodiment is illustrated. This embodiment is similar to that of Figs. 12A and 12B, but a diode interconnector 3f is connected to a front electrode not a back electrode of an adjacent solar battery cell 2 of a solar battery cell 2 on which a bypass diode 4A is mounted.

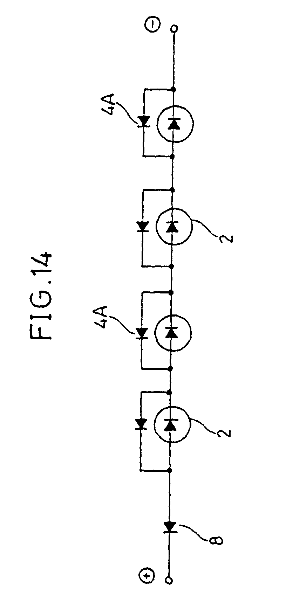

In the above-described many embodiments, any solar battery module may include a diode 8 for preventing a reverse current as exemplified in the equivalent circuit diagram of Fig. 14. This reverse current preventing diode 8 is a pellet-like diode and may be attached on a solar battery cell 2 on one end of a plurality of series-connected solar battery cells 2.

Moreover, while a bypass diode is provided at one place on a single solar battery cell in any of the foregoing embodiments, bypass diodes may be mounted at two or more places on one solar battery cell, thereby enabling a reduction in a resistance developed when a current flows through the bypass diodes.

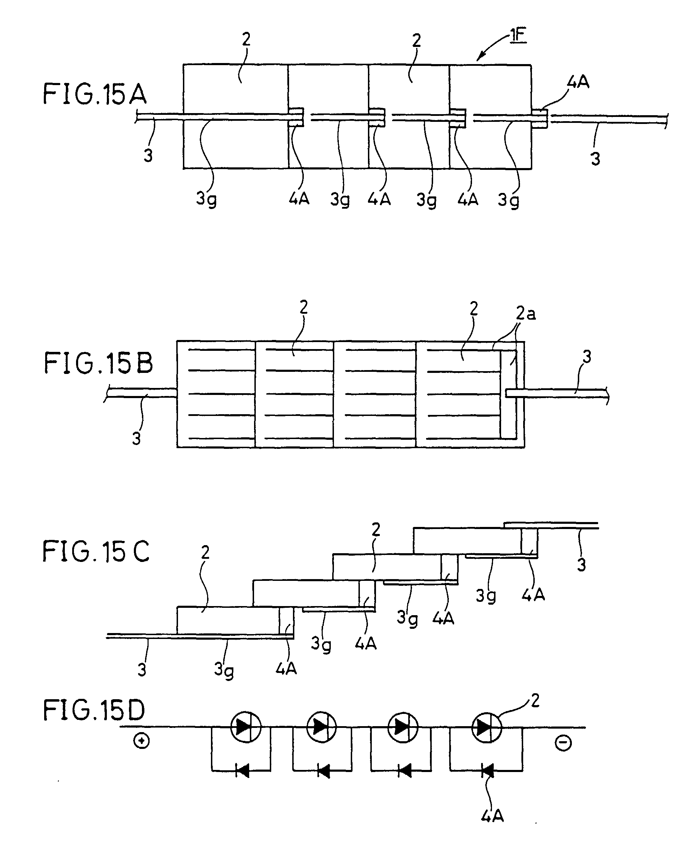

Figs. 15A, 15B, 15C and 15D show, respectively, a bottom view, a top view, a longitudinal cross-sectional view and an equivalent circuit diagram of a solar battery module which is not in accordance with the present invention. In this solar battery module 1F, each of solar battery cells 2 having a comb tooth-like front electrode 2a has a thin plate form and a relatively small size of, e.g., 30 x 30 x 0.4mm³, and a back electrode (not shown) is formed on an approximately entire back surface of each cell. The plurality of solar battery cells 2 are roof-tile-stacked with portions of the respective cells 2 being overlapped with each other, whereby a part of the front electrode 2a is directly connected to the back electrode of an adjacent solar battery cell 2.

The solar battery module 1F of Figs. 15A and 15C further includes pellet-like bypass diodes 4A each having a thin plate form of a relatively small size of, e.g., 3 x 3 x 0.4mm³. Each bypass diode 4A is disposed in an edge portion of the solar battery cell 2 to be bypassed by that bypass diode, and one main surface of the pellet-like diode 4A is attached onto the back electrode of an adjacent cell 2 of the solar battery cell 2 to be bypassed. The other main surface of the bypass diode 4A is attached onto an interconnector 3g which extends and is soldered on the back electrode of the solar battery cell 2 to be bypassed by that diode 4A.

In the solar battery module of Figs. 15A, 15B and 15C, complicate interconnections or connections are simplified which have been necessary between the conventional bypass diodes 4 and the solar battery cells 2. Further, since the pellet-like bypass diodes 4A are attached onto step portions of the roof-tile-stacked solar battery cells 2, the thickness of the solar battery module IF is not increased. In addition, since the bypass diodes 4A are attached on the back surface of the solar battery module 1F, the front surface of the module 1F has a good appearance.

Figs. 16A, 16B and 16C illustrate the state where a crack 2K is produced in one of the solar battery cells 2 in the solar battery module 1F of Figs. 15A, 15B and 15C. Figs 16A, 16B and 16C show, respectively, a bottom view, a top view and a longitudinal cross-sectional view. As will be apparent from these figures, even if the crack 2K occurs, an electrical continuity of the back electrode of the cracked solar battery cell 2 is retained by the interconnector 3g thereon, resulting in no substantial decrease in the output of the entire solar battery module 1F. It will also be understood that a photovoltaic force applied from a hatched area 2F in Fig. 16B can still contribute to the output of the solar battery module 1F even in the solar battery cell 2 having the crack 2K produce therein.

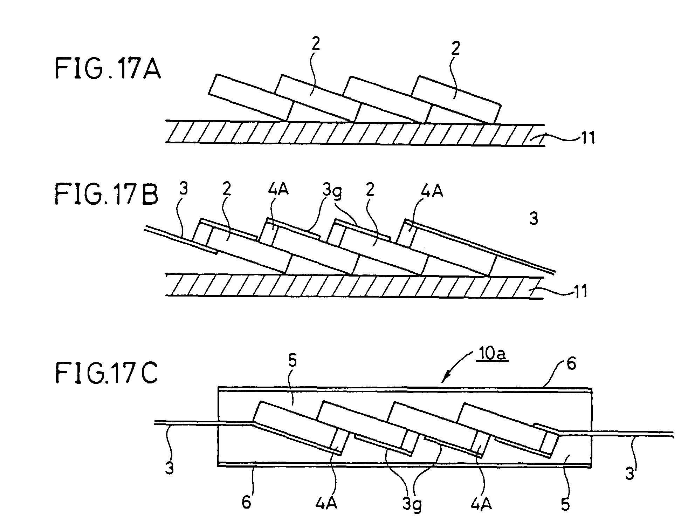

With reference to cross-sectional views of Figs. 17A, 17B and 17C, the step of assembling the solar battery module as shown in Fig. 15C is illustrated. Referring to Fig. 17A, solar battery cells 2 are arranged in a roof-tile-stacked manner on, e.g., an aluminum plate 11 with the back surfaces of the cells facing upward. Referring to Fig. 17B, pellet-like bypass diodes 4A are attached onto step portions of the roof-tile-stacking, and interconnectors 3g cut in an appropriate length are extended over the back electrode from the diodes 4A to the solar battery cells 2. With this state maintained, if the solar battery module is placed on a hot plate heated to two hundred and several tens°C or put in an oven, the diodes 4A and the interconnectors 3g are soldered. After the soldering is completed, the solar battery module is taken out from the hot plate or the oven and then undergoes natural cooling. It will be understood that by use of a jig having an appropriate groove or a positioning pin, the solar battery cells can be connected in a roof-tile-stacked manner with their front surfaces facing upward.

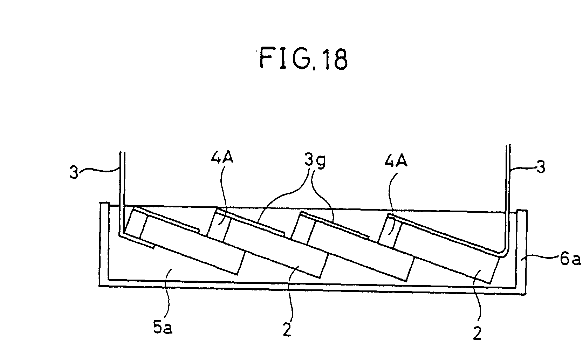

After that, the solar battery module is laminated (heated under pressure) with a filling resin 5 such as EVA resin and a transparent film 6, as shown in Fig. 17C. This completes a solar battery module 10a of roof-tile-stacked type laminated with a protection layer. Alternatively, the solar battery module can be set in a polycarbonate container 6a with a light receiving surface of each solar battery cell facing downward, and can be hardened by being filled with a silicone resin 5a for protection, as shown in a cross-sectional view of Fig. 18.

As has been described heretofore, according to the present invention, since a pellet-like diode as thin as a solar battery cell is directly attached as a bypass diode in a solar battery module, on an electrode of the solar batter cell or on an interconnector, it is possible to provide a solar battery module which has a good appearance and a high value as commodities and can be thinly laminated together with protection layers easily at a low cost without damaging a thin solar battery cell.

## Claims

1. A solar battery module, comprising:
- a plurality of solar battery cells (2) which are electrically series-connected and arranged in a matrix array of rows and columns, each of said cells (2) including a front electrode (2a) and a back electrode (2b), each front electrode including a plurality of parallel conductors (2a) located on a light receiving front side of each cell (2) and extending in one direction, and
- at least one pellet-like thin bypass diode (4A) which allows output currents of said solar battery cells (2) to be by-passed with respect to at least one of said solar battery cells (2), said bypass diode (4A) being attached on an electrode (2a, 2b) of said solar battery cell (2),
**characterized in that** each of said solar battery cells (2) includes one bypass diode (4A), which is directly attached to one of said parallel conductors (2a) of a front electrode of a cell and to an adjacent cell by an interconnector (3, 3a) wherein said one bypass diode (4A) is on a line in which said interconnectors are aligned, and in that a bypass diode (4A) is provided for each of two adjacent rows of said matrix array allowing output currents of said solar battery cells (2) of the respective two adjacent rows to be bypassed with respect to said plurality of solar battery cells, said bypass diode being attached to the front electrode (2a) of the end cell of one of said row and connected by means of a connector (3c,3d,3e) to an electrode (2a,2b) of the end cell of the adjacent row.

2. The solar battery module according to claim 1, said bypass diode (4A) is provided for bypassing current of every two rows of cells of the matrix array, and said interconnector (3c) connects said bypass diode to a back electrode of the adjacent cell of said adjacent row of cells.

3. The solar battery module according to claim 1, said bypass diode (4A) being provided for bypassing current of every two rows of cells (2) of the matrix array, and said respective interconnector (3d) connects said bypass diode to a front electrode of the adjacent cell of said adjacent row.

4. The solar battery module according to claim 1, wherein a single bypass diode (4A) is provided for bypassing current of two adjacent cells (2) which are on opposite ends of said series-connected solar battery cells and are directly connected by means of an interconnector (3e, 3f) to two output terminals (1a) of said solar battery module (10).

5. The solar battery module according to claim 4, wherein said diode interconnector (3e) is connected to a back electrode (2b) of the adjacent cell of said adjacent row.

6. The solar battery module according to claim 4, wherein said diode interconnector (3f) is connected to a front electrode of the adjacent cell of said adjacent row.

7. The solar battery module according to one of the preceding claims, wherein said bypass diode (4A) has a thickness of approximately not more than 0.5 mm.

8. The solar battery module according to one of the preceding claims, wherein said solar battery module is laminated together with a protection layer (5, 6).

## Patentansprüche

1. Solarzellenmodul mit:
- mehreren Solarzellen (2), die elektrisch in Reihe geschaltet sind und in einer Matrixanordnung von Zeilen und Spalten angeordnet sind, wobei jede der Zellen (2) eine Vorderelektrode (2a) und eine Rückelektrode (2b) aufweist, wobei jede Vorderelektrode mehrere parallele Leiter (2a) aufweist, die an einer Licht empfangenden Vorderseite jeder Zelle (2) liegen und sich in einer Richtung erstrecken; und
- mindestens einer tablettenförmigen, dünnen Umgehungsdiode (4A), die es ermöglicht, Ausgangsströme der Solarzellen (2) hinsichtlich mindestens einer der Solarzellen (2) zu umgehen, wobei diese Umgehungsdiode (4A) an einer Elektrode (2a, 2b) der Solarzelle (2) befestigt ist;
**dadurch gekennzeichnet, dass** jede der Solarzellen (2) eine Umgehungsdiode (4A) aufweist, die unmittelbar an einem der parallelen Verbinder (2a) einer Vorderelektrode einer Zelle sowie an einer benachbarten Zelle mittels eines Verbinders (3, 3a) befestigt ist, wobei diese eine Umgehungsdiode (4A) auf einer Linie liegt, in der die Verbinder ausgerichtet sind und dass für jeweils zwei benachbarte Reihen der Matrixanordnung eine Umgehungsdiode (4A) vorhanden ist, was es ermöglicht, die Ausgangsströme der Solarzellen (2) der jeweiligen zwei benachbarten Zeilen hinsichtlich der mehreren Solarzellen zu umgehen, wobei diese Umgehungsdiode an der Vorderelektrode (2a) der Endzelle einer der Zeilen befestigt ist und über einen Verbinder (3c, 3d, 3e) mit einer Elektrode (2a, 2b) der Endzelle der benachbarten Zeile verbunden ist.

2. Solarzellenmodul nach Anspruch 1, wobei die Umgehungsdiode (4A) dazu vorhanden ist, Strom von jeweils zwei Zeilen von Zellen der Matrixanordnung zu umgehen, und der Verbinder (3c) die Umgehungsdiode mit einer Rückelektrode der benachbarten Zelle in der benachbarten Zeile von Zellen verbindet.

3. Solarzellenmodul nach Anspruch 1, wobei die Umgehungsdiode (4A) vorhanden ist, um Strom von jeweils zwei Zeilen von Zellen (2) der Matrixanordnung zu umgehen und der jeweilige Verbinder (3d) die Umgehungsdiode mit einer Vorderelektrode der benachbarten Zelle in der benachbarten Zeile verbindet.

4. Solarzellenmodul nach Anspruch 1, bei dem eine einzelne Umgehungsdiode (4A) dazu vorhanden ist, den Strom zweier benachbarter Zellen (2) zu umgehen, die an entgegengesetzten Enden der in Reihe geschalteten Solarzellen liegen und unmittelbar mittels eines Verbinders (3e, 3f) mit zwei Ausgangsanschlüssen (1a) des Solarzellenmoduls (10) verbunden sind.

5. Solarzellenmodul nach Anspruch 4, bei dem der Diodenverbinder (3e) mit einer Rückelektrode (2b) der benachbarten Zelle in der benachbarten Zeile verbunden ist.

6. Solarzellenmodul nach Anspruch 4, bei dem der Diodenverbinder (3f) mit einer Vorderelektrode der benachbarten Zelle in der benachbarten Zeile verbunden ist.

7. Solarzellenmodul nach einem der vorstehenden Ansprüche, bei dem die Umgehungsdiode (4A) eine Dicke von ungefähr nicht mehr als 0,5 mm aufweist.

8. Solarzellenmodul nach einem der vorstehenden Ansprüche, bei dem das Solarzellenmodul zusammen mit einer Schutzschicht (5, 6) verlaminiert ist.

## Revendications

1. Module de batterie solaire, comprenant :
- une pluralité de cellules de batterie solaire (2) qui sont électriquement reliées en série et agencées en une matrice de rangées et de colonnes, chacune desdites cellules (2) comprenant une électrode avant (2a) et une électrode arrière (2b), chaque électrode avant comprenant une pluralité de conducteurs parallèles (2a) situés sur une face avant de réception de lumière de chaque cellule (2) et s'étendant dans une direction, et
- au moins une diode de dérivation mince (4A) en forme de pastille qui permet aux courants de sortie desdites cellules de batterie solaire (2) d'être dérivés par rapport à au moins une desdites cellules de batterie solaire (2), ladite diode de dérivation (4A) étant fixée sur une électrode (2a, 2b) de ladite cellule de batterie solaire (2),
caractérisé en ce que chacune desdites cellules de batterie solaire (2) comprend une diode de dérivation (4A), qui est directement fixée à l'un desdits conducteurs parallèles (2a) d'une électrode avant d'une cellule et à une cellule adjacente par un dispositif d'interconnexion (3, 3a) dans lequel ladite diode de dérivation (4A) est sur une ligne sur laquelle lesdits dispositifs d'interconnexion sont alignés, et en ce qu'une diode de dérivation (4A) est prévue pour chacune des deux rangées adjacentes de ladite matrice permettant aux courants de sortie desdites cellules de batterie solaire (2) des deux rangées adjacentes respectives d'être dérivés par rapport à ladite pluralité de cellules de batterie solaire, ladite diode de dérivation étant fixée à ladite électrode avant (2a) de la cellule d'extrémité de l'une desdites rangées et reliée au moyen d'un connecteur (3c, 3d, 3e) à une électrode (2a, 2b) de la cellule d'extrémité de la rangée adjacente.

2. Module de batterie solaire selon la revendication 1, dans lequel ladite diode de dérivation (4A) est prévue pour dériver un courant de chacune des deux rangées de cellules de la matrice, et ledit dispositif d'interconnexion (3c) relie ladite diode de dérivation à une électrode arrière de la cellule adjacente de ladite rangée adjacente de cellules.

3. Module de batterie solaire selon la revendication 1, ladite diode de dérivation (4A) étant prévue pour dériver le courant de chacune des deux rangées de cellules (2) de la matrice, et ledit dispositif d'interconnexion respectif (3d) relie ladite diode de dérivation à une électrode avant de la cellule adjacente de ladite rangée adjacente.

4. Module de batterie solaire selon la revendication 1, dans lequel une seule diode de dérivation (4A) est prévue pour dériver un courant de deux cellules adjacentes (2) qui sont sur des extrémités opposées desdites cellules de batterie solaire reliées en série et qui sont directement reliées, au moyen d'un dispositif d'interconnexion (3e, 3f) à deux bornes de sortie (1a) dudit module de batterie solaire (10).

5. Module de batterie solaire selon la revendication 4, dans lequel ledit dispositif d'interconnexion de diode (3e) est relié à une électrode arrière (2b) de la cellule adjacente de ladite rangée adjacente.

6. Module de batterie solaire selon la revendication 4, dans lequel ledit dispositif d'interconnexion de diode (3f) est relié à une électrode avant de la cellule adjacente de ladite rangée adjacente.

7. Module de batterie solaire selon 1' une des revendications précédentes, dans lequel ladite diode de dérivation (4A) a une épaisseur non supérieure à environ 0,5 mm.

8. Module de batterie solaire selon l'une quelconque des revendications précédentes, dans lequel ledit module de batterie solaire est stratifié en même temps qu'une couche de protection (5, 6).
